# EUROPÄISCHE PATENTSCHRIFT

(11) **EP 3 767 830 B1**
(45) Veröffentlichungstag und Bekanntmachung des Hinweises auf die Patenterteilung: **23.08.2023**
(21) Anmeldenummer: 19186214.3
(22) Anmeldetag: 15.07.2019
(51) Int. Cl.: H03K 17/96, H03K 17/955, H03K 17/975, G06F 3/041, G06F 3/044

(54) **KAPAZITIVE SCHALT-VORRICHTUNG MIT DRUCKSENSOR**
CAPACITIVE SWITCHING DEVICE WITH PRESSURE SENSOR
DISPOSITIF DE COMMUTATION CAPACITIF AVEC CAPTEUR DE PRESSION

(43) Veröffentlichungstag der Anmeldung: 20.01.2021
(73) Patentinhaber: RAFI GmbH & Co. KG, 88276 Berg (DE)
(72) Erfinder: KRAFT, Markus, 88250 Weingarten (DE); MENNIG, Sebastian, 88353 Kißlegg (DE); HOFMANN, 88361 Wolfegg (DE); BULACH, Eric, 88074 Meckenbeuren (DE); FLEISCHER, frank, 88368 Bergatreute (DE); KNÜPPEL, Volker, 88090 Immenstaad (DE)
(74) Vertreter: Christ, Niko

(56) Entgegenhaltungen:
- EP-A1- 2 492 786
- EP-A1- 3 309 967
- WO-A1-2011/107195
- DE-A1- 19 703 206
- US-A1- 2012 068 938

## Beschreibung

Die Erfindung bezieht sich auf eine kapazitive Schalt-Vorrichtung zur Umwandlung einer manuellen oder mechanischen Zustellbewegung in ein elektrisches Schaltsignal, durch das ein elektrisches Gerät gesteuert ist, nach dem Oberbegriff des Patentanspruchs 1.

Eine solche kapazitive Schalt-Vorrichtung kann beispielsweise der EP 3 309 966 A1 entnommen werden. Durch diese Schalt-Vorrichtung erzeugen Sensoren vereinzelte elektrische Felder, die jeweils einer Schaltfläche zugeordnet sind. Sobald die elektrischen Felder, insbesondere deren Kapazität, durch das Eindringen eines Gegenstandes, beispielsweise eines menschlichen Fingers, verändert ist, entsteht ein der jeweiligen Schaltfläche zugeordnetes Schaltsignal.

Um die Redundanz oder Schaltsicherheit der Schaltvorrichtung zu erhöhen, ist zwischen der Abdeckplatte und dem Gehäuse ein Sensor angeordnet, der in einem elastischen verformbaren Sensor-Körper angeordnet ist. Der in dem Körper vorgesehene Sensor erzeugt ein elektrisches Feld, das mit den Innenwänden des Körpers derart zusammenwirkt, dass bei einer Abstandsveränderung die entsprechende Kapazitätsveränderung messbar und auswertbar ist. Somit können die Schaltkontakte dahingehend überprüft werden, ob tatsächlich eine entsprechende Betätigung oder Schaltung gewünscht ist, denn die Abdeckplatte ist zusätzlich zu der Veränderung des elektrischen Feldes jeder Schaltfläche in das Innere des Schaltgehäuses zu bewegen. Aufgrund dieser Bewegung der Abdeckplatte entsteht eine Verformung des Sensor-Körper.

Als nachteilig bei dieser Schalt-Vorrichtung hat sich herausgestellt, dass die Herstellung des Sensor-Körpers äußerst kostenaufwendig ist und dass dessen Montage mit einem hohen Aufwand zu bewerkstelligen ist, da zum einen die Genauigkeit und Zuverlässigkeit der Sensoren über den gesamten Umfang des SchaltGehäuses vorhanden sein muss und zum anderen sind die entsprechenden Kapazitäts-Veränderungen im Bereich der jeweiligen Sensoren zu erfassen und auszuwerten. Sobald jedoch einer der notwendigen Sensoren ausfällt oder dessen Positionierung verrutscht, entstehen Störungen und die erforderliche Redundanz durch die zweiten Schaltsignale geht verloren.

Es ist daher Aufgabe der Erfindung, eine Schalt-Vorrichtung der eingangsgenannten Gattung derart weiterzubilden, dass die Montage und Herstellung der für die Schalt-Vorrichtung erforderlichen Bauteile kostengünstig und zeitsparend erfolgt und gleichzeitig eine dauerhafte und zuverlässige Schaltüberprüfungsfunktion vorhanden ist.

Diese Aufgabe ist erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass zwischen der Abdeckplatte und dem Gehäuse ein elastisch verformbarer Schlauch eingesetzt ist, und mindestens eine Hohlkammer einschließt, dass in der mindestens einen Hohlkammer des Schlauches ein Medium vorgesehen ist, und dass in den Schlauch mindestens eine Öffnung eingearbeitet ist, in die ein Drucksensor eingesetzt ist oder dass in jeder der mindestens einen Hohlkammer ein Drucksensor angeordnet ist, derart, dass der jeweilige Drucksensor die Druckschwankungen des Mediums in der jeweiligen Hohlkammer erfasst und diese an die Auswerteeinrichtung zur physikalischen Berechnung des Druckzustandes im Inneren des Schlauches weiterleitet, ist gewährleistet, dass die Bewegung der Abdeckplatte zuverlässig erfassbar ist, denn durch die Zustellkraft und der damit verbundenen Zustellbewegung der Abdeckplatte in das Innere des Gehäuses werden die Hohlkammern des Schlauches zusammengedrückt, wodurch eine Druckzustandserhöhung entsteht.

Diese Druckveränderung kann unverzüglich mittels der Drucksensoren erfasst und durch eine Auswerteeinrichtung entsprechend in ein zweites zusätzliches Schaltsignal umgewandelt sein. Somit ist die gewünschte, das elektrische Feld der jeweiligen Schaltfläche verändernde Zustellbewegung überprüft und die Auswerteeinrichtung erzeugt ein Schaltsignal zur Steuerung einer elektrisch betriebenen Werkzeugmaschine oder eines sonstigen elektrischen Gerätes erst nachdem das redundante Schaltsignal durch die Drucksensoren generiert ist. Bereits äußerst geringe Druckveränderungen sind demnach messbar und gegebenenfalls in redundante Schaltsignale umzuwandeln.

Die Montage und Herstellung des Schlauches, der für die Druckveränderungen und deren Messungen erforderlich ist, kann problemlos und kostengünstig erfolgen, denn hierbei handelt es sich um einen Massenartikel und die entsprechende Anordnung und Ausrichtung zwischen der Abdeckplatte und dem Gehäuse erfolgt unkompliziert und ohne Zeitverzögerung.

Es ist besonders vorteilhaft, wenn in dem Schlauch eine Vielzahl von Hohlkammern vorgesehen ist, denn dadurch können die unterschiedlichen Druckzustände jeder Hohlkammern erfasst sein, wodurch eine Berechnung möglich ist, auf welcher Schaltposition tatsächlich die Zustellkraft einwirkt. Wenn diese Position der Zustellkraft mit der Veränderung des elektrischen Feldes übereinstimmt, kann eine ortsaufgelöste Redundanz der Schalt-Vorrichtung erreicht sein.

Die für die Messung der Druckveränderung erforderlichen Bauteile sind kostengünstig herstell- und montierbar. Zudem können diese Bauteile teilweise außerhalb der Schalt-Vorrichtung angeordnet sein, so dass die Betriebsweise der kapazitiven Schalt-Vorrichtung durch die weiteren erforderlichen Messungen nicht beeinträchtigt ist.

In der Zeichnung ist eine erfindungsgemäße Schalt-Vorrichtung dargestellt, die nachfolgend näher erläutert ist. Im Einzelnen zeigt:
- Figur 1a: eine kapazitiv betriebene Schalt-Vorrichtung, bestehend aus einem Gehäuse, in dem eine Aufnahmeöffnung eingearbeitet ist und aus einer in die Aufnahmeöffnung beweglich gelagerten Abdeckplatte und aus einem zwischen der Abdeckplatte und dem Gehäuse angeordneten Schlauch mit einer Hohlkammer, in der ein Medium zur Erfassung von Druckveränderungen vorgesehen ist, im Schnitt und im unbetätigten Zustand,
- Figur 1b: die Schalt-Vorrichtung gemäß Figur 1a, im betätigten Zustand,
- Figur 2a: die Schalt-Vorrichtung gemäß Figur 1a mit einer in dem Schlauch eingearbeiteten Öffnung, an die eine Pumpe und ein Drucksensor angeschlossen ist, in Draufsicht und
- Figur 2b: die Schalt-Vorrichtung gemäß Figur 1b mit einem in den Schlauch eingearbeiteten Öffnung, an der eine Pumpe und ein Drucksensor angeschlossen ist und mit einer an den Drucksensor und der Pumpe elektrisch angeschlossenen Auswerteeinrichtung, im betätigten Zustand.

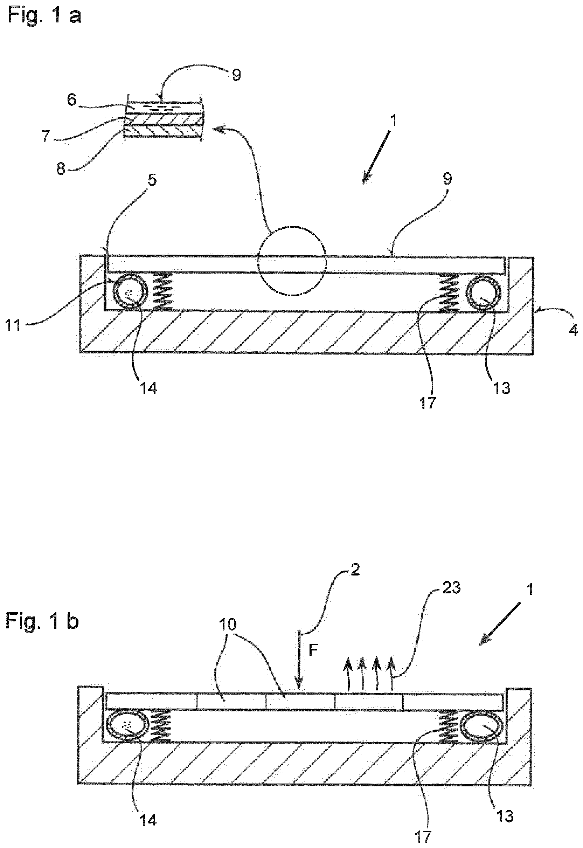

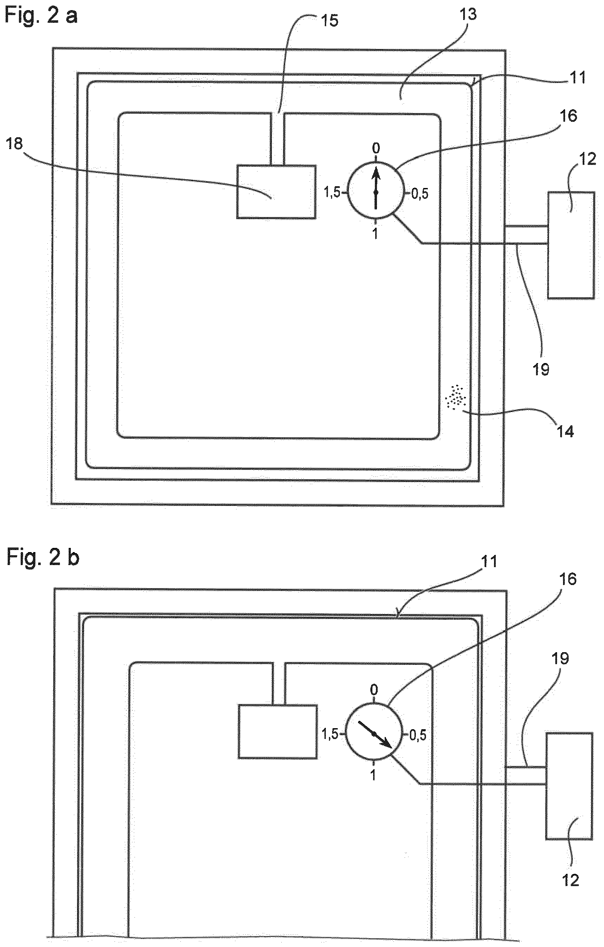

In den Figuren 1a, 1b, 2c und 2b ist eine kapazitiv betriebene Schalt-Vorrichtung 1 zu entnehmen, durch die eine manuelle oder mechanische Zustellbewegung 2 in ein elektrisches Schaltsignal mithilfe einer Auswerteelektronik 12 umgewandelt ist. Die Auswerteelektronik 12 ist dabei sowohl über elektrische Leitungen 19 mit der Vorrichtung 1 als auch mit einem nicht dargestellten elektrischen Gerät, beispielsweise einer Werkzeugmaschine, verbunden. Somit dient die Auswerteelektronik 12 gemeinsam mit der Vorrichtung 1 dazu, die jeweiligen Zustellbewegungen 2, beispielsweise eines menschlichen Fingers, in ein elektrisches Schaltsignal zur Steuerung der an die Auswerteelektronik 12 angeschlossenen elektrischen Geräte umzuwandeln.

Die Schalt-Vorrichtung 1 besteht aus einem Gehäuse 4, in das eine rechteckförmige Aufnahmeöffnung 5 eingearbeitet ist. Es ist ohne weiteres vorstellbar, eine Art Gitterstruktur in die derart ausgestaltete Aufnahmeöffnung 5 einzusetzen, durch die einzelnen Sektoren oder Felder gebildet sind, die jeweils einer bestimmten Schaltfläche zugeordnet sein können.

Die Aufnahmeöffnung 5 ist mit einem Touch-Screen 6, einer transparenten Abdeckplatte 7 und einem Display 8 verschlossen, die eine gemeinsame Baueinheit 9 bilden. Auf dem Display 8 sind dabei eine Vielzahl von Schaltflächen 10 vorgesehen, die über den Touch-Screen 6 und die Abdeckplatte 7 von einem Benutzer der Vorrichtung 1 von außen ohne weiteres erkennbar sind. Folglich kann jede Zustellbewegung 2 einer bestimmten Schaltfläche 10 von dem Benutzer zugeordnet sein, um die entsprechenden damit verbundenen Schaltsignale durch die Auswerte-Einrichtung 12 zu generieren. Jede Schaltfläche 10 ist dabei ein von der Touch-Screen 6 erzeugtes elektrisches Feld 23 zugeordnet, dessen Kapazität beim Eindringen eines Gegenstandes verändert ist.

Üblicherweise sind solche kapazitive Schalt-Vorrichtungen 1 in bestimmten Anwendungen fehlerbehaftet, denn diese können beispielsweise durch Umwelteinflüsse in Form von Wassertropfen, Verschmutzungen oder sonstigen Störungen beeinflusst sein, die ein unerwünschtes Schaltsignal auslösen. Manche elektrischen Geräte, wie beispielsweise Telefone, stellen kein Gefahrenpotenzial bei einer unerwünschten Fehlfunktion dar. Allerdings sind Werkzeugmaschinen oftmals in Gefahrenbereichen aufgestellt bzw. deren Fehlfunktionen können zu Gefahrensituation für den jeweiligen Benutzer führen. Folglich sollen solche Fehlfunktionen, insbesondere durch unerwünschte Umwelteinflüsse, ausgeschlossen sein und die Schalt-Vorrichtung 1 soll erst dann betriebsbereit zur Erzeugung eines Schaltsignals sein, wenn durch ein zusätzliches unabhängiges Steuersignal die jeweilige Schaltfläche 10 freigegeben ist.

Um eine zusätzliche und damit redundante Schaltfunktion zur Verfügung zu stellen, ist zwischen der Baueinheit 9 bzw. der Abdeckplatte 7 und dem Gehäuse 4 ein umlaufender Schlauch 11 angeordnet. Der Schlauch 11 besteht aus einem biegeelastischen Werkstoff, der eine vorgegebene Steifigkeit oder Biegefestigkeit aufweist. Der Schlauch 11 ist im Randbereich der jeweiligen Aufnahmeöffnung 5 vorgesehen. In dem Schlauch 11 ist ein Medium 14 eingefüllt. Üblicherweise wird für das Medium 14 Umgebungsluft verwendet. Es ist jedoch auch denkbar, ein Medium 14 mit höherer oder niederer Dichte, also flüssig oder gasförmig, in den Schlauch 11 einzufüllen, um dadurch den Druckzustand im Inneren des Schlauches 11 zu verändern.

Der Schlauch 11 besteht somit aus mindestens einer Hohlkammer 13, in der das Medium 14 eingeschlossen ist. Wenn die jeweilige Hohlkammer 13 vollständig geschlossen ist, wirkt das Medium 14 im Inneren der Hohlkammer 13 der Zustellbewegung 2 entgegen.

Zudem soll durch die Verformung des Schlauches 11 bei der Zustellbewegung ein zusätzliches relevantes Schaltsignal erzeugt werden. Daher ist in den Schlauch 11 mindestens eine Öffnung 15 eingearbeitet, die jeweils in einer der Hohlkammem 13 mündet. Sobald auf die Abdeckplatte 7 eine entsprechend groß bemessene Betätigungskraft F einwirkt, bewegt sich daher die im Gehäuse 4 bzw. dessen Aufnahmeöffnung 5 axial beweglich gelagerte Abdeckplatte 7 in Richtung des Inneren des Gehäuses 4 und der im seitlichen Bereich der Aufnahmeöffnung 5 angeordnete Schlauch 11 wird durch die Betätigungskraft F zusammengedrückt, wodurch in den jeweiligen Hohlkammern 13 des Schlauches 11 eine Druckzustandsveränderung erfolgt. Das Medium 14 kann nämlich aufgrund der Druckveränderung durch die jeweilige Öffnung 15 entweichen, so dass zum einen die Zustellbewegung 2 durch die Druckerhöhung in der Hohlkammer 13 nicht behindert ist und gleichzeitig kann zum anderen die Druckveränderung in der Hohlkammer 13 durch einen an der Öffnung 15 vorgesehenen Drucksensor 16 erfasst werden. Je mehr Medium 14 aus der Öffnung 15 ausströmen, desto größer ist die Druckveränderung, die von dem Drucksensor 16 erfasst ist.

Der Drucksensor 16 ist über elektrische Leitungen 19 mit der Auswertelektronik 12 elektrisch gekoppelt, so dass die von dem Drucksensor 16 ermittelten Druckveränderungswerte von der Auswerteelektronik 12 erfasst und ausgewertet sind.

Wenn demnach auf die Abdeckplatte 7 gemäß den Figuren 1b und 2b eine entsprechend hohe Betätigungskraft F einwirkt und eine Druckveränderung in der Hohlkammer 13 durch den Drucksensor 16 erfasst ist, ermittelt die Auswerteelektronik 12 ein zweites redundantes Schaltsignal, wodurch die jeweilige Schaltfläche 10 des Displays 8 freigegeben ist.

Wenn der Schlauch 11 in eine Vielzahl von Hohlkammern 13 unterteilt ist, an denen jeweils einer der Drucksensoren 16 angeschlossen sind, dann kann durch die Auswerteelektronik 12 sogar die Position ermittelt sein, auf die die Betätigungskraft F auf die Abdeckplatte 7 einwirkt. Eine solche Positionsbestimmung kann anschließend durch die Auswerteelektronik 12 mit dem erzeugten Schaltsignal der Schaltfläche 10 in Beziehung gesetzt werden, um darüber hinaus zu verifizieren, dass nicht nur die Schaltfläche 10 freigeschaltet, sondern sogar die tatsächliche Position der Betätigungskraft F auf die Abdeckplatte 7 bzw. der Schaltfläche 10 des Displays 8 ermittelbar ist.

Gemäß den Figuren 2a und 2b kann an die Öffnung 15 der jeweiligen Hohlkammer 13 eine Pumpe 18 angeschlossen sein, durch die der Druck im Inneren der Hohlkammer 13 einstellbar ist. Der im Schlauch 11 herrschende Druck beeinflusst nämlich die Schalter der Abdeckplatte 7. Je höher der eingestellte Druck im Schlauch 11 ist, desto größer ist die aufzuwendende Betätigungskraft F bzw. umgekehrt.

## Patentansprüche

1. Kapazitive Schalt-Vorrichtung (1) zur Umwandlung einer manuellen oder mechanischen Zustellbewegung (2) in ein elektrisches Schaltsignal, durch das ein elektrisches Gerät gesteuert ist,
bestehend aus:
- einem Gehäuse (4), in das eine Aufnahmeöffnung (5) eingearbeitet ist,
- einem in der Aufnahmeöffnung (5) des Gehäuses (4) angeordneten Touchscreen (6), der nach außen von einer elektrisch isolierend wirkenden Abdeckplatte (7) und nach innen von einem Display (8) umschlossen ist,
- wobei die Abdeckplatte (7), der Touchscreen (6) und das Display (8) eine Baueinheit (9) bilden, die in der Aufnahmeöffnung (5) des Gehäuses (4) axial beweglich gelagert ist,
- wobei der Touchscreen (6) und das Display (8) mindestens eine kapazitiv betriebene Schaltfläche (10) aufweisen, welche bei der Annäherung eines menschlichen Fingers oder eines mechanischen Zustellgliedes geschaltet wird,
- und aus einer mit der jeweiligen Schaltfläche (10) elektrisch gekoppelten Auswerteeinrichtung (12), durch die bei einer Veränderung des elektrischen Feldes (23) ein der jeweiligen Schaltfläche (10) entsprechendes Schaltsignal generiert ist,
wobei zwischen der Abdeckplatte (7) und dem Gehäuse (4) ein elastisch verformbarer Schlauch (11) eingesetzt ist, der mindestens eine Hohlkammer (13) einschließt und wobei in der mindestens einen Hohlkammer (13) des Schlauches (11) ein Medium (14) vorgesehen ist,
**dadurch gekennzeichnet,**
**dass** in den Schlauch (11) mindestens eine Öffnung (15) eingearbeitet ist, in die ein Drucksensor (16) eingesetzt ist oder dass in jeder der mindestens einen Hohlkammer (13) ein Drucksensor (16) angeordnet ist, derart, dass der jeweilige Drucksensor (16) die Druckschwankungen des Mediums (14) in der jeweiligen Hohlkammer (13) erfasst und diese an die Auswerteeinrichtung (12) zur physikalischen Berechnung des Druckzustandes im Inneren des Schlauches (11) weiterleitet.

2. Schalt-Vorrichtung nach Patentanspruch 1,
**dadurch gekennzeichnet,**
**dass** durch den Schlauch (11) die im Inneren des Gehäuses (4) angeordnete Baueinheit (9) wasser-, staub- und/oder gasdicht verschlossen ist und der Schlauch somit als Dichtung wirkt.

3. Schalt-Vorrichtung nach Patentanspruch 1 oder 2,
**dadurch gekennzeichnet,**
**dass** durch eine auf die Abdeckplatte (7) einwirkende Betätigungskraft (F) der Druckzustand im Inneren des Schlauches (11), insbesondere in jeder der vorhandenen Hohlkammern (13) des Schlauches (11), verändert ist und dass jede Druckänderung durch die Auswerteeinrichtung (12) erfasst und in ein redundantes Schaltsignal umgewandelt ist.

4. Schalt-Vorrichtung nach Patentanspruch 3,
**dadurch gekennzeichnet,**
**dass** bei mehreren Hohlkammern (13) eine Zuordnung der jeweilig entstehenden Druckzustände in jeder der Hohlkammern (13) durch die Auswerteeinrichtung (12) ermittelbar ist und dass durch die Zuordnung, in welcher der Hohlkammern (13) die größte Druckänderung durch die Betätigungskraft (F) stattfindet, eine Positionsbestimmung ermöglicht bzw. durchführbar ist, derart, dass die jeweilige Schaltfläche (10) erkannt ist, auf die die Betätigungskraft (F) einwirkt.

5. Schalt-Vorrichtung nach einem der vorgenannten Ansprüche,
**dadurch gekennzeichnet,**
**dass** zwischen der Abdeckplatte (5) und dem Gehäuse (4) Federelemente (17) angeordnet sind, durch den Touch-Screen (6), die Abdeckplatte (7) und das Display (8) in der Aufnahmeöffnung (5) gegenseitig in Position gehalten sind.

6. Schalt-Vorrichtung nach einem der vorgenannten Ansprüche,
**dadurch gekennzeichnet,**
**dass** jede Hohlkammer (13) mit einem Ausgangsdruckzustand betrieben ist, durch den die Schalthaptik der Abdeckplatte (7) beinflussbar bzw. einstellbar ist.

7. Schalt-Vorrichtung nach Anspruch 6,
**dadurch gekennzeichnet,**
**dass** an die Öffnung (15) des Schlauches (11) eine Pumpe (18) angeschlossen ist, durch die das Medium (14) in die jeweilige Hohlkammer (13) einpressbar oder absaugbar ist.

## Claims

1. Capacitive switching apparatus (1) for converting a manual or mechanical feed movement (2) into an electrical switching signal by means of which an electrical device is controlled, consisting of:
- a housing (4), in which a receiving opening (5) is incorporated,
- a touch screen (6) arranged in the receiving opening (5) of the housing (4) and surrounded on the outside by an electrically insulating cover plate (7) and on the inside by a display (8),
- wherein the cover plate (7), the touch screen (6) and the display (8) form an assembly (9) which is axially movably mounted in the receiving opening (5) of the housing (4),
- wherein the touch screen (6) and the display (8) have at least one capacitively operated button (10) which is switched when a human finger or a mechanical feed member approaches,
- and an evaluation device (12) electrically coupled to the relevant button (10), by means of which device a switching signal corresponding to the relevant button (10) is generated when the electrical field (23) changes,
wherein
an elastically deformable tube (11) is inserted between the cover plate (7) and the housing (4), said tube including at least one hollow chamber (13), and wherein a medium (14) is provided in the at least one hollow chamber (13) of the tube (11),
**characterized in that**
at least one opening (15) is incorporated into the tube (11), into which opening a pressure sensor (16) is inserted, or **in that** a pressure sensor (16) is arranged in each of the at least one hollow chambers (13) in such a way that the relevant pressure sensor (16) detects the pressure fluctuations of the medium (14) in the relevant hollow chamber (13) and forwards said pressure fluctuations to the evaluation device (12) for the physical calculation of the pressure state in the interior of the tube (11).

2. Switching apparatus according to claim 1,
**characterized in that**
the assembly (9) arranged in the interior of the housing (4) is closed in a watertight, dust-tight and/or gas-tight manner by the tube (11) and the tube thus acts as a seal.

3. Switching apparatus according to either claim 1 or claim 2,
**characterized in that**
the pressure state in the interior of the tube (11), in particular in each of the existing hollow chambers (13) of the tube (11), is changed by an actuating force (F) acting on the cover plate (7), and **in that** each pressure change is detected by the evaluation device (12) and converted into a redundant switching signal.

4. Switching apparatus according to claim 3,
**characterized in that**
if there are a plurality of hollow chambers (13), an assignment of the relevant resulting pressure states in each of the hollow chambers (13) by the evaluation device (12) can be determined and **in that** by assigning in which of the hollow chambers (13) the greatest pressure change by the actuating force (F) takes place, a position determination is made possible or can be carried out in such a way that the relevant button (10) on which the actuating force (F) acts is identified.

5. Switching apparatus according to any of the preceding claims,
**characterized in that**
spring elements (17) are arranged between the cover plate (5) and the housing (4), by means of which spring elements the touch screen (6), the cover plate (7) and the display (8) are held in position in the receiving opening (5).

6. Switching apparatus according to any of the preceding claims,
**characterized in that**
each hollow chamber (13) is operated with an initial pressure state by means of which the switching haptics of the cover plate (7) can be influenced or adjusted.

7. Switching apparatus according to claim 6,
**characterized in that**
a pump (18) is connected to the opening (15) of the tube (11), by means of which pump the medium (14) can be pressed or suctioned into the relevant hollow chamber (13).

## Revendications

1. Dispositif de commutation capacitif (1) permettant de convertir un mouvement d'avance manuel ou mécanique (2) en un signal de commutation électrique, par lequel un appareil électrique est commandé, constitué par :
- un boîtier (4) dans lequel est ménagée une ouverture de réception (5),
- un écran tactile (6) disposé dans l'ouverture de réception (5) du boîtier (4), lequel écran tactile est entouré vers l'extérieur par une plaque de recouvrement (7) agissant de manière électriquement isolante et vers l'intérieur par un affichage (8),
- dans lequel la plaque de recouvrement (7), l'écran tactile (6) et l'affichage (8) forment une unité structurale (9) qui est montée de manière axialement mobile dans l'ouverture de réception (5) du boîtier (4),
- dans lequel l'écran tactile (6) et l'affichage (8) présentent au moins une surface de commutation (10) fonctionnant de manière capacitive et commutée lors de l'approche d'un doigt humain ou d'un organe d'avance mécanique,
- et par un appareil d'évaluation (12) couplé électriquement à la surface de commutation (10) respective et par lequel un signal de commutation correspondant à la surface de commutation (10) respective est généré lors d'une modification du champ électrique (23),
dans lequel
un tuyau (11) élastiquement déformable est inséré entre la plaque de recouvrement (7) et le boîtier (4), lequel tuyau renferme au moins une chambre creuse (13), et dans lequel un milieu (14) est prévu dans l'au moins une chambre creuse (13) du tuyau (11),
**caractérisé en ce**
**qu'**au moins une ouverture (15) est ménagée dans le tuyau (11), dans laquelle un capteur de pression (16) est inséré, **ou en ce qu'**un capteur de pression (16) est disposé dans chacune de l'au moins une chambre creuse (13), de manière telle que le capteur de pression (16) respectif détecte les oscillations de pression du milieu (14) dans la chambre creuse (13) respective et les transmet à l'appareil d'évaluation (12) pour le calcul physique de l'état de pression à l'intérieur du tuyau (11).

2. Dispositif de commutation selon la revendication de brevet 1,
**caractérisé en ce**
**que** l'unité structurale (9) disposée à l'intérieur du boîtier (4) est fermée de manière étanche à l'eau, à la poussière et/ou au gaz par le tuyau (11) et le tuyau fonctionne ainsi comme joint d'étanchéité.

3. Dispositif de commutation selon la revendication de brevet 1 ou 2,
**caractérisé en ce**
**que** l'état de pression à l'intérieur du tuyau (11), en particulier dans chacune des chambres creuses (13) présentes du tuyau (11), est modifié par une force d'actionnement (F) agissant sur la plaque de recouvrement (7) **et en ce que** chaque modification de pression est détectée par l'appareil d'évaluation (12) et convertie en un signal de commutation redondant.

4. Dispositif de commutation selon la revendication de brevet 3,
**caractérisé en ce**
**que,** dans le cas de plusieurs chambres creuses (13), une affectation des états de pression respectivement générés dans chacune des chambres creuses (13) peut être déterminée par l'appareil d'évaluation (12) **et en ce que**, grâce à l'affectation de la chambre creuse parmi les chambres creuses (13) dans laquelle se produit la plus grande modification de pression par la force d'actionnement (F), une détermination de position est permise ou réalisable de manière telle que la surface de commutation (10) respective sur laquelle la force d'actionnement (F) agit est reconnue.

5. Dispositif de commutation selon l'une des revendications précédentes,
**caractérisé en ce**
**que** des éléments de ressort (17) sont disposés entre la plaque de recouvrement (5) et le boîtier (4), avec lesquels éléments de ressort l'écran tactile (6), la plaque de recouvrement (7) et l'affichage (8) sont maintenus mutuellement en position dans l'ouverture de réception (5).

6. Dispositif de commutation selon l'une des revendications précédentes,
**caractérisé en ce**
**que** chaque chambre creuse (13) fonctionne avec un état de pression de départ avec lequel l'haptique de commutation de la plaque de recouvrement (7) peut être influencée ou réglée.

7. Dispositif de commutation selon la revendication 6,
**caractérisé en ce**
**qu'**une pompe (18) est raccordée à l'ouverture (15) du tuyau (11), avec laquelle pompe le milieu (14) peut être comprimé ou aspiré dans la chambre creuse (13) respective.
